# DEMANDE DE BREVET EUROPEEN

(11) **EP 4 723 369 A1**
(43) Date de publication de la demande: **08.04.2026**
(21) Numéro de dépôt: 25205077.8
(22) Date de dépôt: 26.09.2025
(51) Int. Cl.: H01P 5/107, H05K 1/02, H05K 3/46

(54) **SUBSTRAT STRATIFIÉ POUR DISPOSITIF RADIOFREQUENCE**

(30) Priorité: 01.10.2024 FR 2410534
(71) Demandeur: STMicroelectronics International N.V., 1228 Plan-les-Ouates, Geneva (CH)
(72) Inventeur: VELAYUDHAN, Vipin, 38100 Grenoble (FR); COGONI, Deborah, 38470 Notre Dame de l'Osier (FR)
(74) Mandataire: Cabinet Beaumont

(57) **Abrégé**

La présente description concerne un substrat stratifié (100) pour dispositif radiofréquence comprenant successivement :
- une première couche métallique (110), dans laquelle est formée une première cavité (116) ouverte au moins partiellement sur un de ses côtés, une ligne d'alimentation (400) s'étendant dans la première cavité (116),
- une deuxième couche métallique (120) dans laquelle est formée une deuxième cavité (126) fermée latéralement,
- une troisième couche métallique (130) dans laquelle est formée une troisième cavité (136) fermée latéralement,
- une quatrième couche métallique (140) dans laquelle est formée une quatrième cavité (146) fermée latéralement, des plots de connexion (500) étant fixé sur la quatrième couche métallique (400),

la deuxième cavité (126), la troisième cavité (136) et la quatrième cavité (146) formant une traversée RF verticale,
une plaque métallique (340) étant positionnée dans la quatrième cavité (316).

## Description

### Domaine technique

La présente description concerne de façon générale les substrats pour dispositif électronique émettant et/ou recevant des signaux radiofréquence. De tels dispositifs trouvent, par exemple, des applications dans le domaine des radars automobiles par exemple dans les systèmes automobiles d'aide à la conduite (ADAS pour 'Advanced Driver Assistance Systems').

### Technique antérieure

Typiquement, dans les dispositifs ADAS, des signaux radiofréquences (76 GHz-81GHz) sont émis et reçus par des antennes. Les délais d'émission et de réception sont utilisés pour calculer la distance de l'objet. Ensuite, plusieurs radars avec des algorithmes de traitement d'image sont utilisés pour identifier la forme de l'objet. Ce type de système ou de fonction est appelé RADAR.

Les dispositifs peuvent avoir plusieurs architectures. Dans les dispositifs ayant une architecture de lanceur sur boîtier (LoP pour 'Launcher on Package'), une puce est placée sur la face supérieure d'un substrat de type BGA ('Ball Grid Array'), lui-même disposé sur un circuit imprimé (PCB) muni de trous traversants. Un module de guide antenne comprenant une antenne et un guide d'onde est placé sur l'autre côté du PCB.

Ainsi, les signaux peuvent aller de la puce au module antenne à travers le PCB.

Pour transmettre un signal depuis la puce au PCB, des antennes patch ('patch antenna'), sous forme de plaque métallique, sont positionnées sur la face inférieure du substrat BGA, et disposées en correspondance avec les trous de passage du PCB. Elles ont une forme et une taille spécifiques pour résonner à la fréquence désirée. Cependant, la connexion RF à travers le substrat BGA et l'antenne peuvent entraîner à la fois une perte de transmission et une perte de largeur de bande. Un décalage et/ou une diminution des fréquences peut également être observé. Une solution connue à ce problème consiste à créer des trous de passage plus grands dans le circuit imprimé, ce qui augmente la taille du dispositif final.

Il existe un besoin d'améliorer la transmission du signal et/ou d'augmenter la largeur de bande du signal sans augmenter la taille du dispositif.

### Résumé de l'invention

Un mode de réalisation pallie tout ou partie des inconvénients des dispositifs connus.

Un mode de réalisation prévoit un substrat stratifié pour dispositif radiofréquence comprenant depuis une première face principale vers une deuxième face principale :
- une première couche métallique dans laquelle est formée une première cavité ouverte au moins partiellement sur un de ses côtés, et une ligne d'alimentation, disposée de manière coplanaire à la première couche métallique et s'étendant dans la première cavité,
- une deuxième couche métallique dans laquelle est formée une deuxième cavité fermée latéralement,
- une troisième couche métallique dans laquelle est formée une troisième cavité fermée latéralement,
- une quatrième couche métallique dans laquelle est formée une quatrième cavité fermée latéralement, la deuxième cavité, la troisième cavité et la quatrième cavité formant une traversée radiofréquence verticale dans le substrat,
une plaque métallique étant positionnée au moins dans la quatrième cavité.

Selon un mode de réalisation, une plaque métallique additionnelle est positionnée dans la troisième cavité.

Selon un mode de réalisation, la plaque métallique additionnelle positionnée dans la troisième cavité a des dimensions différentes des dimensions de la plaque métallique positionnée dans la quatrième cavité.

Selon un mode de réalisation, une autre plaque métallique est positionnée dans la deuxième cavité.

Selon un mode de réalisation, la première cavité, la deuxième cavité, la troisième cavité et la quatrième cavité ont des dimensions différentes.

Selon un mode de réalisation, la troisième cavité a des dimensions inférieures aux dimensions de la quatrième cavité et supérieures aux dimensions de la deuxième cavité.

Selon un mode de réalisation, la plaque métallique de la quatrième cavité est positionnée au centre de la quatrième cavité.

Selon un mode de réalisation, la plaque métallique positionnée dans la quatrième cavité est décalée par rapport au centre de la quatrième cavité.

Un autre mode de réalisation prévoit un dispositif radiofréquence comprenant :
- un substrat stratifié tel que défini précédemment,
- une puce radiofréquence montée sur la première face du substrat stratifié, la puce radiofréquence étant connectée à la ligne d'alimentation, moyennant quoi la puce radiofréquence est couplée à la traversée radiofréquence verticale du substrat stratifié.

Un autre mode de réalisation prévoit un système d'émission/réception d'un signal radiofréquence, comprenant un dispositif radiofréquence tel que défini précédemment, positionné sur une première face d'un circuit imprimé, un module antenne étant disposé sur une deuxième face du circuit imprimé, le module antenne comprenant des guides d'ondes et des antennes couplés au dispositif radiofréquence grâce à des trous traversant le substrat du circuit imprimé.

Un autre mode de réalisation prévoit un procédé de fabrication d'un substrat stratifié tel que défini précédemment comprenant les étapes suivantes :
- déposer la deuxième couche métallique et la troisième couche métallique, de part et d'autre de la deuxième couche diélectrique,
- former des cavités, fermées latéralement, dans la deuxième couche métallique et la troisième couche métallique,
- déposer la première couche diélectrique et la troisième couche diélectrique de part et d'autre, respectivement, de la deuxième couche métallique et la troisième couche métallique,
- former la première couche métallique et la quatrième couche métallique de part et d'autre, respectivement, de la première couche diélectrique et la troisième couche diélectrique,
- former une cavité ouverte sur un de ses côtés dans la première couche métallique, et former une cavité fermée latéralement dans la quatrième couche métallique,
- positionner une plaque métallique dans la cavité de la quatrième couche métallique,
- former une ligne d'alimentation, destinée à être connectée à une puce, la ligne d'alimentation étant coplanaire à la première couche métallique et s'étendant dans la première cavité ouverte.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique d'une vue de côté d'un substrat stratifié selon un mode de réalisation particulier ;
la figure 2A et la figure 2B sont des représentations schématiques d'une vue en coupe et de côté de différents substrats stratifiés selon deux modes de réalisation particuliers ;
la figure 3A, la figure 3B, la figure 3C, la figure 3D sont des représentations schématiques en vue de dessus, respectivement, de la première couche métallique, de la deuxième couche métallique, de la troisième couche métallique et de la quatrième couche métallique d'un substrat, et la figure 3E est une représentation schématique, en vue de dessous, de la quatrième couche métallique et d'un guide d'onde oblong (par exemple de 2.54 mm x 1 mm ou 2.54 mm x 1.1 mm), selon un autre mode de réalisation particulier ;
la figure 4 est une représentation schématique en trois dimensions d'un substrat stratifié comprenant les couches métalliques des figures 3A à 3D et le guide d'onde oblong de la figure 3E;
la figure 5A, la figure 5B, la figure 5C, la figure 5D sont des représentations schématiques en vue de dessus, respectivement, de la première couche métallique, de la deuxième couche métallique, de la troisième couche métallique et de la quatrième couche métallique d'un substrat, et la figure 5E est une représentation schématique, en vue de dessous, de la quatrième couche métallique et d'un guide d'onde oblong (par exemple de 2.54 mm x 1 mm), selon un autre mode de réalisation particulier ;
la figure 6 est une représentation schématique en trois dimensions d'un substrat stratifié comprenant les couches métalliques des figures 5A à 5D et le guide d'onde oblong de la figure 5E;
la figure 7A, la figure 7B, la figure 7C, la figure 7D sont des représentations schématiques en vue de dessus, respectivement, de la première couche métallique, de la deuxième couche métallique, de la troisième couche métallique et de la quatrième couche métallique d'un substrat, et la figure 7E est une représentation schématique, en vue de dessous, de la quatrième couche métallique et d'un guide d'onde oblong fin (par exemple de 2.54 mm x 0.55 mm), selon un autre mode de réalisation particulier ;
la figure 8 est une représentation schématique en trois dimensions d'un substrat stratifié comprenant les couches métalliques des figures 7A à 7D et le guide d'onde de la figure 7E;
la figure 9A, la figure 9B, la figure 9C, la figure 9D sont des représentations schématiques en vue de dessus, respectivement, de la première couche métallique, de la deuxième couche métallique, de la troisième couche métallique et de la quatrième couche métallique d'un substrat, et la figure 9E est une représentation schématique, en vue de dessous, de la quatrième couche métallique et d'un guide d'onde oblong fin (par exemple de 2.54 mm x 0.55 mm), selon un autre mode de réalisation particulier ;
la figure 10 est une représentation schématique en trois dimensions d'un substrat stratifié comprenant les couches métalliques des figures 9A à 9D et le guide d'onde de la figure 9E;
la figure 11A, la figure 11B, la figure 11C, la figure 11D et la figure 11E sont des représentations schématique et en vue de dessus de la troisième couche métallique de différents substrats selon différents mode de réalisation particuliers ;
la figure 12A, la figure 12B, la figure 12C, la figure 12D et la figure 12E sont des représentations schématique et en vue de dessus de la quatrième couche métallique de différents substrats selon différents mode de réalisation particuliers ;
la figure 13A, la figure 13B, la figure 13C, la figure 13D sont des représentations schématiques en vue de dessus, respectivement, de la première couche métallique, de la deuxième couche métallique, de la troisième couche métallique et de la quatrième couche métallique d'un substrat, et la figure 13E est une représentation schématique, en vue de dessous, de la quatrième couche métallique et d'un guide d'onde oblong (par exemple 2.54 mm x 1.05 mm), selon un autre mode de réalisation particulier ;
la figure 14A, la figure 14B, la figure 14C, la figure 14D sont des représentations schématiques en vue de dessus, respectivement, de la première couche métallique, de la deuxième couche métallique, de la troisième couche métallique et de la quatrième couche métallique d'un substrat, et la figure 14E est une représentation schématique, en vue de dessous, de la quatrième couche métallique et d'un guide d'onde oblong fin (par exemple 2.54 mm x 0.55 mm), selon un autre mode de réalisation particulier ;
la figure 14F et la figure 14G sont des représentations schématiques, en trois dimensions, respectivement d'un empilement comprenant les couches métalliques des figures 14A, 14B, 14C et 14D et d'un empilement comprenant les couches métalliques des figures 14B, 14C et 14D (la première couche métallique de la figure 14A n'étant pas ici représentée afin de mieux visualiser la traversée verticale RF formée dans le substrat) ;
la figure 15A, la figure 15B, la figure 15C, la figure 15D sont des représentations schématiques en vue de dessus, respectivement, de la première couche métallique, de la deuxième couche métallique, de la troisième couche métallique et de la quatrième couche métallique d'un substrat, et la figure 15E est une représentation schématique, en vue de dessous, de la quatrième couche métallique et d'un guide d'onde en forme de U (par exemple de 1.6 mm x 1.0 mm), selon un autre mode de réalisation particulier ;
la figure 16 est une représentation schématique d'une vue en coupe d'un dispositif radiofréquence, selon un autre mode réalisation particulier ;
la figure 17 est une représentation schématique d'une vue en coupe d'un système d'émission/réception d'un signal RF, selon un autre mode réalisation particulier;
la figure 18 est un graphique représentant les simulations des paramètres S11, S22 et S21 en fonction de la fréquence pour deux substrats stratifiés selon différents modes de réalisation particuliers ;
la figure 19 est une simulation d'un abaque de Smith des paramètres S11 et S22 pour deux substrats stratifiés selon différents modes de réalisation particuliers ;
la figure 20 est une simulation représentant la propagation d'ondes électromagnétiques ('propagation of E-field') dans un système d'émission/réception selon un mode de réalisation particulier de l'invention ;
la figure 21 est un graphique représentant les simulations des paramètres S11, S22 et S21 en fonction de la fréquence pour un substrat stratifié selon un autre mode de réalisation particulier ;
la figure 22 est une simulation d'un abaque de Smith des paramètres S11 et S22 pour un substrat stratifié selon un autre mode de réalisation particulier ;
la figure 23 est une simulation représentant la propagation d'ondes électromagnétiques ('propagation of E-field') dans un système d'émission/réception selon un autre mode de réalisation particulier de l'invention ;
la figure 24, la figure 25 et la figure 26 sont des graphiques représentant les performances électriques obtenues de différents dispositifs ayant des substrats selon différents modes de réalisation particuliers.

Les figures ne sont pas nécessairement à une échelle uniforme afin de les rendre plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des modes de réalisation décrits et les utilisations de l'antenne ne sont pas décrites.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures. En particulier, le terme propagation verticale ou traversée RF verticale fait référence à une propagation ou une traversée RF selon l'axe z.

Sauf précision contraire, les expressions "environ", "approximativement", "sensiblement", et "de l'ordre de" signifient à 10 % près, de préférence à 5 % près.

Par entre X et Y, on entend que les bornes X et Y sont incluses.

Le substrat qui va être décrit par la suite peut être utilisé pour des applications radiofréquences. Par radiofréquence (RF), on entend des fréquences comprises entre 3 kHz et 300 GHz, et plus particulièrement des fréquences comprises entre 76 GHz et 81 GHz pour la fabrication de radars automobiles de type ADAS. Même si la description mentionne en particulier les fréquences d'environ 76GHz à 81GHz, d'autres fréquences peuvent être utilisées pour d'autres dispositifs utilisant d'autres radiofréquences.

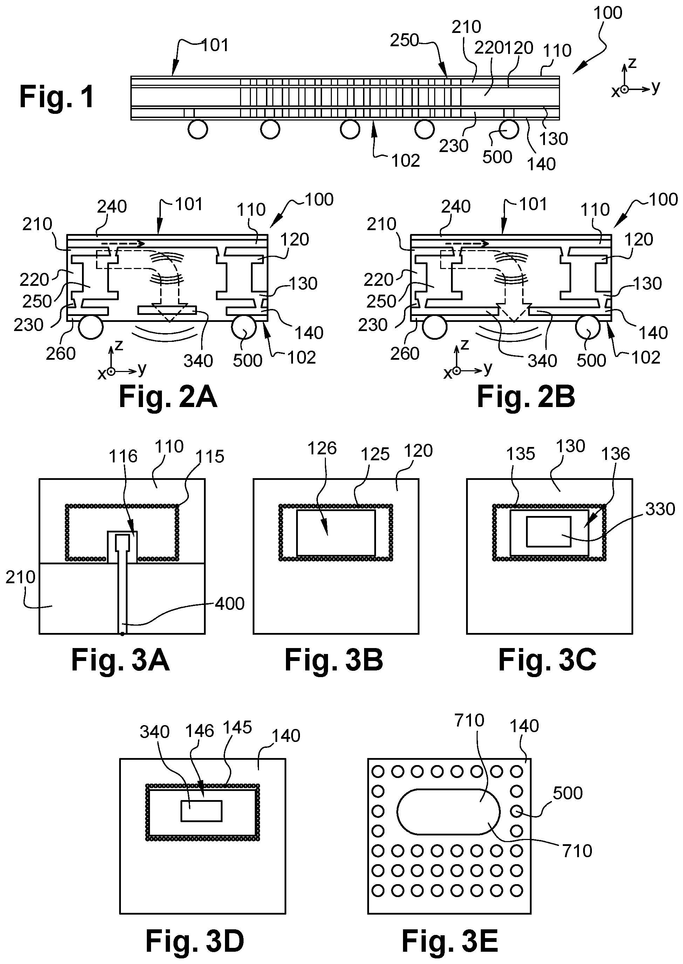

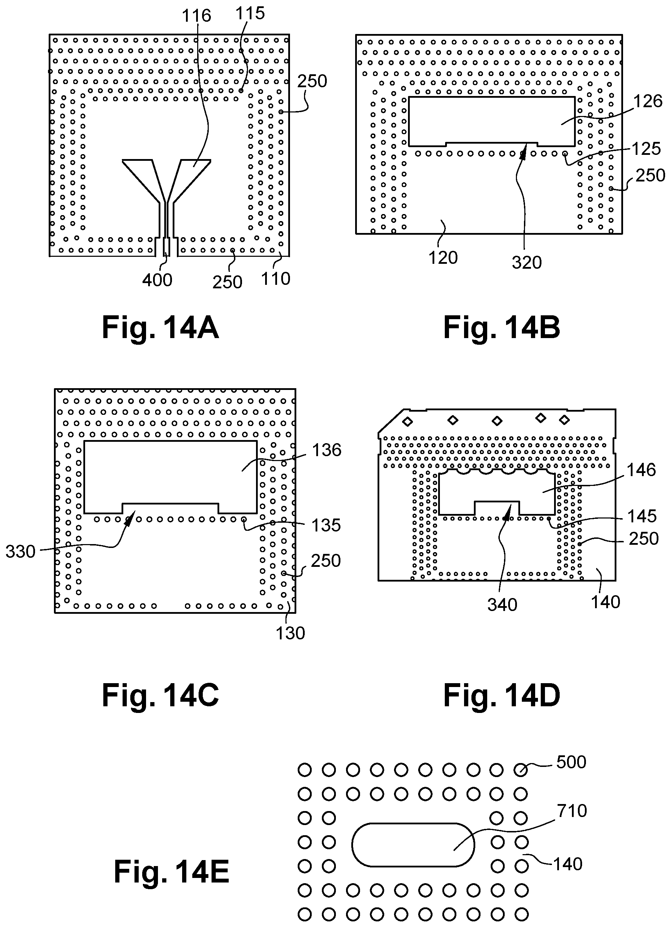

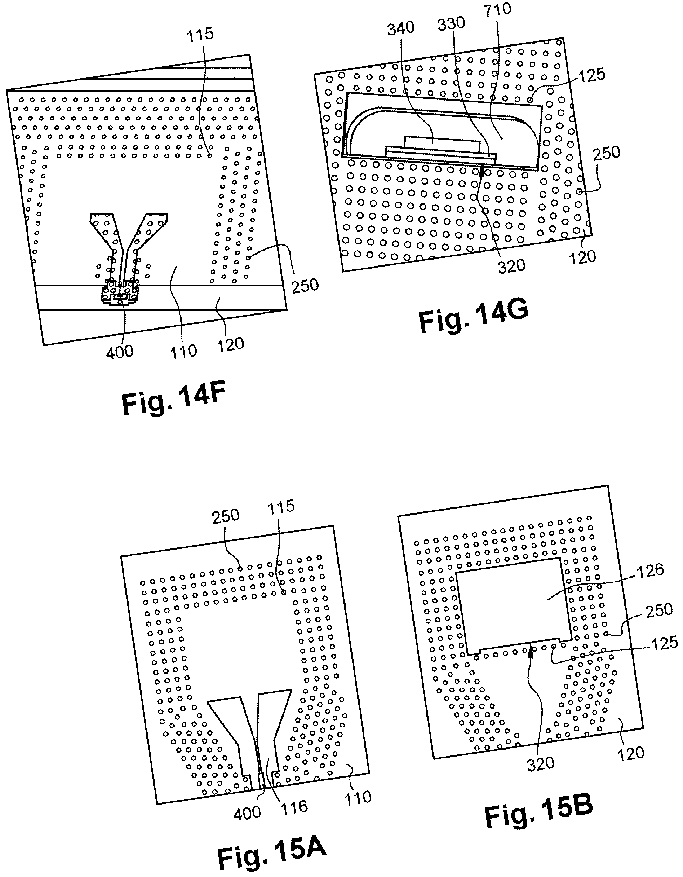

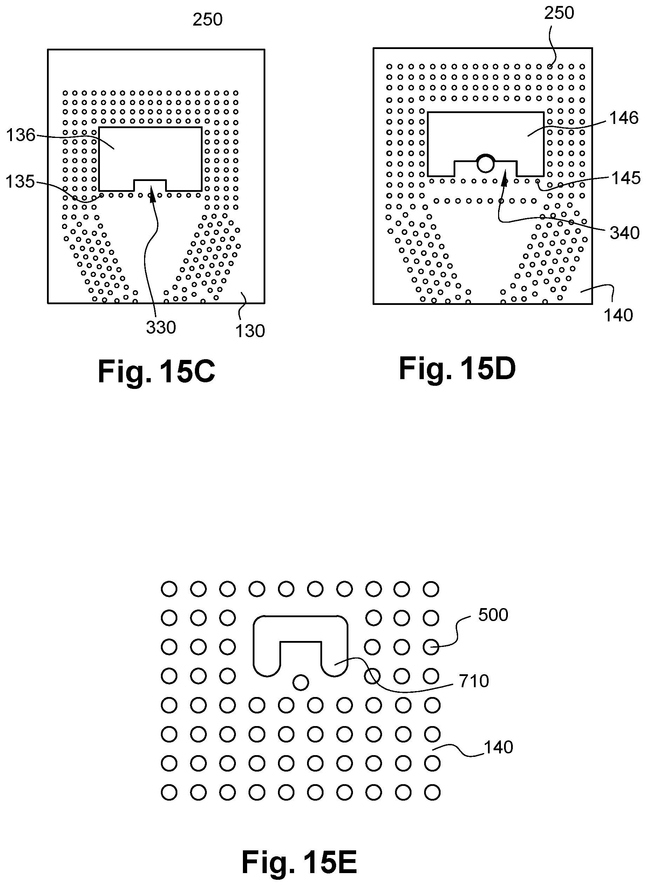

Nous allons maintenant décrire plus en détail le substrat stratifié 100 en faisant référence aux figures 1, 2A et 2B, 3A à 3E, 4, 5A à 5E et 6, 7A à 7E et 8, 9A à 9E et 10, 11A à 11E, 12A à 12E, 13A à 13E, 14A à 14G et 15A à 15E.

Le substrat stratifié 100 est un substrat à matrice de billes (aussi appelé substrat BGA pour 'Ball Grid Array').

Le substrat 100 comprend une première face principale 101 et une deuxième face principale 102 (figures 1, 2A et 2B).

La première face principale 101 peut être connectée à une puce ou plusieurs puces et la deuxième face principale 102 peut être assemblée à un circuit imprimé 700 (PCB pour 'printed circuit board'). La deuxième face 102 du substrat 100 est recouverte d'une matrice de billes 500. Les billes 500 sont des plots de connexion permettant de fixer le substrat 100 sur un dispositif externe 700, par exemple un circuit imprimé. Il est également possible d'assembler deux substrats stratifiés l'un à l'autre, par exemple en les assemblant en miroir (structure en 'U').

Le substrat 100 comprend au moins quatre couches métalliques 110, 120, 130, 140 depuis la première face principale 101 jusqu'à la deuxième face principale 102. La première couche métallique 110 se situe du côté de la première face 101. La quatrième couche métallique 140 se situe du côté de la deuxième face 102. La première couche métallique 110 est la couche supérieure du substrat 100 et la quatrième couche métallique 140 est la couche inférieure du substrat 100.

Nous décrirons par la suite quatre couches métalliques mais il pourrait y avoir plus de quatre couches métalliques (cinq ou six par exemple), par exemple en ajoutant des couches métalliques intermédiaires entre les couches métalliques précitées.

Les couches métalliques 110, 120, 130, 140 peuvent être en un métal ou en un alliage de métaux. Elles sont par exemple, en un matériau choisi parmi l'or, le cuivre, l'aluminium, un alliage de cuivre et d'aluminium. Les couches métalliques 110, 120, 130, 140 ont, par exemple, une épaisseur comprise entre 5 et 50 µm, de préférence entre 5 et 35 µm, et encore plus préférentiellement entre 15 et 25 µm. Les couches métalliques 110, 120, 130, 140 ont, par exemple, une épaisseur de 40 µm.

Par exemple, les couches métalliques 110, 120, 130, 140 sont des feuilles métalliques, des feuilles de cuivre notamment.

La deuxième couche métallique 120, la troisième couche métallique 130 et la quatrième couche métallique 140 peuvent avoir de mêmes dimensions ou des dimensions différentes. Leurs surfaces peuvent être carrées ou rectangulaires.

La première couche métallique 110 peut avoir une surface inférieure à la surface des autres couches métalliques 120, 130, 140 (figures 3A, 5A, 7A, 9A par exemple).

Les différentes couches métalliques 110, 120, 130, 140 sont positionnées les unes au-dessus des autres. Les couches métalliques 110, 120, 130, 140 sont séparées les unes des autres par des couches diélectrique 210, 220, 230 afin de les isoler les unes des autres.

On obtient un empilement comprenant une alternance de couches métalliques 110, 120, 130, 140 et de couches diélectriques 210, 220, 230 (figures 2A et 2B). L'empilement du substrat stratifié 100 comprend successivement depuis la première face principale 101 jusqu'à la deuxième face principale 102 :
- la première couche métallique 110 (figures 3A, 5A, 7A, 9A, 13A, 14A, 15A),
- la première couche diélectrique 210,
- la deuxième couche métallique 120 (figures 3B, 5B, 7B, 9B, 13B, 14B, 15B),
- la deuxième couche diélectrique 220,
- la troisième couche métallique 130 (figures 3C, 5C, 7C, 9C, 11A à 11E, 13C, 14C, 15C),
- la troisième couche diélectrique 230,
- la quatrième couche métallique 140 (figures 3D, 5D, 7D, 9D, 12A à 12E, 13D et 13E, 14D et 14E, 15D et 15E).

Des couches diélectriques additionnelles 240, 260 peuvent être disposées de part et d'autre de l'empilement précédemment décrit afin d'isoler les couches métalliques 110, 140 (figures 2A et 2B).

Les couches diélectriques 210, 220, 230, 240, 260 sont en un matériau permettant la transmission du champ électromagnétique. Les couches diélectriques 210, 220, 230, 240, 260 sont, par exemple, formées d'un matériau dit pré-imprégné (ou 'prepreg'). Par matériau pré-imprégné, on entend un matériau composite comprenant un polymère thermoplasqtique ou une résine thermodurcissable et des charges, par exemple des fibres de verre. Les couches diélectriques peuvent également être en ABF ('Ajinomoto's Insulation film^{®}').

La deuxième couche diélectrique 220 forme le cœur de l'empilement ('core') et peut être en un matériau différent des autres couches diélectriques 210, 230, 240, 260. Elle est, par exemple, en une résine pouvant contenir des fibres, notamment des fibres de verre, par exemple en une résine époxy contenant des fibres de verre. Elle peut être en un matériau FR-4('Flame Retardant 4'). La deuxième couche diélectrique 220 peut avoir une épaisseur comprise entre 100 et 150 µm.

Des cavités ('slot') 116, 126, 136, 146 sont formées dans les couches métalliques 110, 120, 130, 140 de chaque niveau. La deuxième cavité 126, la troisième cavité 136 et la quatrième cavité 146 sont alignées selon l'axe z afin de former une traversée radiofréquence verticale (aussi appelée traversée RF ou 'feedthrough RF'). Il y a une transition de 90 degrés du mode Quasi-TEM (microruban ou ligne de transmission) au mode TE (guide d'ondes).

Par cavité, on entend une zone de la couche métallique au sein de laquelle il y a une absence de matière créant ainsi une zone vide qui s'étend à travers toute l'épaisseur de la couche métallique, créant ainsi un passage ou un trou qui connecte les deux surfaces opposées de la couche métallique. Une fois la cavité 116, 126, 136, 146 formée, cette zone peut être remplie par un ou plusieurs matériaux. Par exemple, cette zone peut être remplie, partiellement ou totalement, par le matériau diélectrique de la couche diélectrique inférieure ou supérieure et/ou par l'élément d'adaptation positionné au sein de la cavité (dans le centre de la cavité ou décalée par rapport au centre de la cavité). La cavité 116, 126, 136, 146 comprend, de préférence, au moins quatre côtés. Elle est par exemple rectangulaire. La cavité 126, 136, 146 est dite fermée latéralement lorsque tous ses bords sont entourés par la couche métallique. La cavité 116 est dite ouverte lorsqu'au moins un de ses bords n'est pas formé par la couche métallique.

La première cavité 116 est formée dans la première couche métallique 110. La première cavité 116 est une cavité ouverte dans laquelle s'étend la ligne de transmission 400 (aussi appelée ligne d'alimentation). La ligne de transmission est disposée de manière coplanaire à la première couche métallique 110 (i.e. elles sont dans le même plan xOy). La ligne de transmission 400 est, par exemple, destinée à être connectée à la puce 610. La ligne de transmission 400 est en métal. Elle peut être, par exemple, en cuivre, en aluminium ou en or. La ligne de transmission 400 comprend un élément longitudinal, tel qu'un fil ou un ruban, et une extrémité. L'extrémité de la ligne de transmission peut avoir une forme carrée, rectangulaire ou triangulaire. La longueur et la largeur de la ligne de transmission dépendent de la fréquence.

Au moins une partie de la ligne de transmission 400 est positionnée dans la première cavité 116. L'extrémité de la ligne de transmission 400 et au moins une partie de l'élément longitudinal est positionnée dans la cavité 116. Les flancs de la ligne de transmission 400 ne sont pas en contact avec la première couche métallique 110. Les flancs de la ligne de transmission 400 sont, par exemple, espacés des bords de la cavité 116 par une distance comprise entre 25 et 300 µm, par exemple une distance de 40 µm, 50 µm ou 200 µm. Pour certaines technologies avancées, il est possible de réduire l'espacement à 10 ou 12 microns, voire à 5 ou 7 microns. L'espacement maximum dépend de la structure et de la position des vias. Par exemple, l'espacement peut aller jusqu'à quelques millimètres. Les différents paramètres sont ajustés en fonction de la bande de fréquence et de l'impédance.

Selon un mode de réalisation particulier, l'extrémité de la ligne de transmission 400 peut être isolée de la couche métallique 110. Autrement dit, la ligne de transmission 400 s'étend dans la première cavité 116, les flancs et l'extrémité de la ligne de transmission n'étant pas en contact avec la première couche métallique 110 (figures 3A, 4, 5A, 6, 7A, 8, 9A, 10).

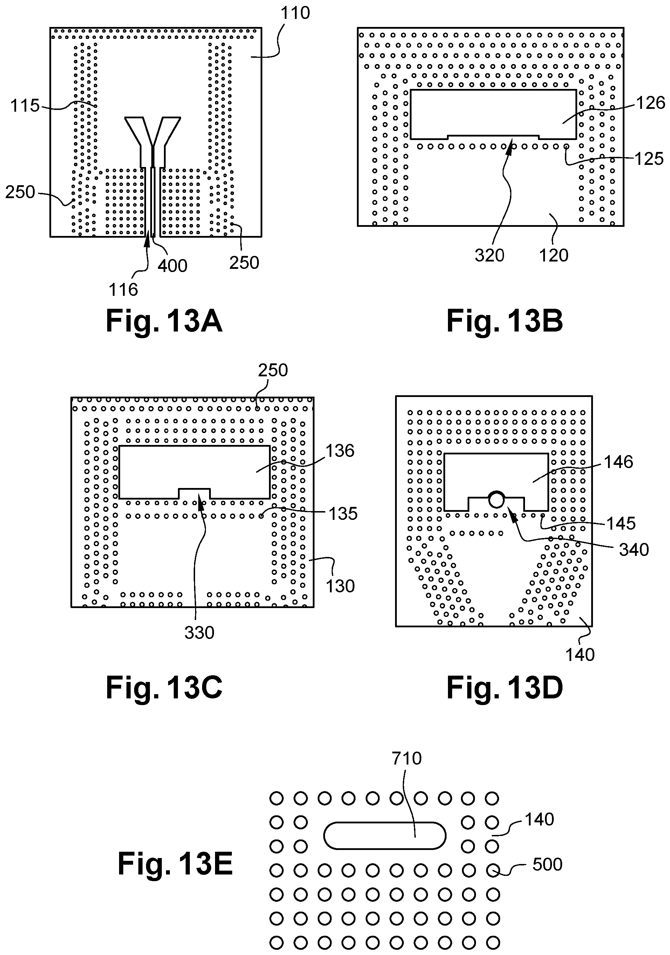

Selon un autre mode de réalisation particulier, l'extrémité de la ligne de transmission 400 peut être en contact avec la première couche métallique 110 (figures 13A, 14A et 15A). L'extrémité des couches métalliques peut être terminée par un bloc de vias qui forme une cavité.

Dans ces différents modes de réalisation, la première couche métallique 110 et la ligne de transmission 400 forment un premier niveau du substrat 100 et jouent le rôle de transformateur d'impédance. En effet, l'impédance de la puce 610 est à une valeur comprise entre 45 et 50 Ω et le guide d'onde du circuit imprimé 700 est à une valeur comprise entre 100 et 600 Ω, voire entre 200 et 600 Ω. L'impédance arrivant dans la ligne de transmission 400 est de 45-50 Ω, elle diminue et passe, par exemple, à 11 Ω en entrée du guide d'onde intégré au substrat SIW ('Substrate Integrated Waveguide'), i.e. au niveau de la deuxième cavité 126. En sortie du SIW du substrat 100, après passage dans la quatrième cavité 146, l'impédance est à une valeur compatible avec celle du circuit imprimé 700, par exemple à une valeur de 570 Ω. A titre illustratif, des impédances de 363 Ω et de 169 Ω ont été obtenues pour des guide d'onde, respectivement, de 2.54 mm x 1.1 mm et 2.54 mm x 0.55 mm.

L'orientation du signal est également modifiée de 90° entre la première cavité 116 et la deuxième cavité 126 (représentées par des flèches sur les figures 2A, 2B), permettant ensuite une propagation verticale du signal à travers les cavités 136, 146.

La deuxième couche métallique 120 comprend une deuxième cavité 126. La deuxième cavité 126 est fermée latéralement. La deuxième cavité 126 peut être positionnée en regard de la ligne de transmission 400 ou être décalée par rapport à la position de la ligne de transmission 400. Elle est, par exemple, accolée à la ligne de transmission 400.

La troisième couche métallique 130 comprend une troisième cavité 136 fermée latéralement.

La quatrième couche métallique 140 comprend une quatrième cavité 146 fermée latéralement. Des plots de connexion 500 (ou billes) sont positionnés sur la deuxième face 102 du substrat 100. Ils sont fixés à la quatrième couche métallique 140. Les plots de connexion 500 forment une matrice de plots. Il n'y a pas de plots au niveau de la quatrième cavité 146.

Au moins les cavités 126, 136, 146 sont positionnées les unes au-dessus des autres selon l'axe z, de manière à former une traversée RF verticale et pouvoir transmettre les radiofréquences de la puce 610 au PCB 700. La traversée RF verticale traverse ainsi les différents niveaux du substrat laminé BGA 100. Cette traversée RF verticale maximise la largeur de bande sans augmenter la taille ou la perte d'insertion.

La deuxième cavité 126, la troisième cavité 136 et la quatrième cavité 146 ont des dimensions différentes les unes des autres et/ou peuvent être décalées les unes par rapport aux autres, au moins une partie des cavités se superposant selon l'axe z pour assurer une traversée verticale RF.

Par exemple, la quatrième cavité 146 a les plus grandes dimensions et la première cavité 116 a les plus petites dimensions.

La taille de la cavité détermine la fréquence et le champ de propagation vers le guide d'ondes (TE10).

Au moins une cavité choisie parmi la deuxième cavité 126, la troisième cavité 136 et la quatrième cavité 146 comprend un élément d'adaptation de la fréquence 320, 330, 340. De préférence, au moins la quatrième cavité 146 comprend un élément d'adaptation 340 (comme par exemple représenté sur les figures 2A et figures 2B).

Sur les figures 3A à 10, un élément d'adaptation 330 est positionné dans la troisième cavité 136 et un élément d'adaptation 340 peut être positionné dans la quatrième cavité 146.

Il est possible d'avoir un élément d'adaptation 330 positionné dans la troisième cavité 136, un élément d'adaptation 340 positionné dans la quatrième cavité 146 ainsi qu'un élément d'adaptation dans la deuxième cavité 126 (figures 13A à 15E).

Les éléments d'adaptation de la fréquence 320, 330, 340 peuvent avoir des dimensions différentes. Les éléments d'adaptation de la fréquence comprennent deux faces principales et des faces latérales. La surface de chaque face principale est dans le plan xOy.

En fonction des caractéristiques recherchées, les éléments d'adaptation de la fréquence peuvent être positionnés au centre de la cavité ou sur les bords de la cavité et/ou avoir des formes différentes. Les éléments d'adaptation ne sont pas forcément alignés les uns avec les autres.

Les éléments d'adaptation de la fréquence 320, 330, 340 sont configurés pour canaliser le signal électromagnétique dans les cavités 126, 136, 146.

Les éléments d'adaptation 320, 330, 340 peuvent être disposés en quinconce afin d'augmenter la largeur de bande.

Les éléments d'adaptation 320, 330, 340 peuvent se superposer partiellement les uns au-dessus des autres (selon l'axe z).

Selon un mode de réalisation, l'élément d'adaptation de la fréquence 320, 330, 340 peut être une plaque ('patch') isolée des bords de la cavité 126, 136, 146 par un espace (figure 2A, figures 3A à 6). La plaque est, par exemple, une plaque métallique. Par exemple, il s'agit d'une plaque en cuivre. La plaque peut être en un même matériau que la couche métallique. Les plaques sont de préférence en un matériau conducteur, de préférence en un métal, par exemple en cuivre, en aluminium, en un alliage de cuivre et d'aluminium ou en or.

Les plaques sont, par exemple, rectangulaires ou carrées. Elles pourraient également être circulaires.

Les plaques peuvent avoir la même épaisseur que les couches métalliques ou une épaisseur identique à 10% voire 5% près.

Selon un autre mode de réalisation, l'élément d'adaptation d'impédance 320, 330, 340 peut être une partie de la couche métallique qui fait saillie dans la cavité (figure 2B, figures 7A à 12E, figures 13A à 15E). Autrement dit, une partie de la couche métallique se prolonge dans la cavité et forme une avancée ou proéminence dans la cavité 126, 136, 146. La partie faisant saillie forme une extension interne de la plaque métallique.

Il va sans dire que si l'élément d'adaptation est une partie de la couche métallique faisant saillie dans la cavité, l'élément d'adaptation sera positionné sur le bord de la cavité ou dans un coin de la cavité.

Les parties faisant saillie sont, par exemple, rectangulaires ou carrées. Les parties faisant saillie ont la même épaisseur que les couches métalliques.

Les formes irrégulières des parties faisant saillie et/ou de la cavité permettent de faire correspondre la fréquence et la largeur de bande.

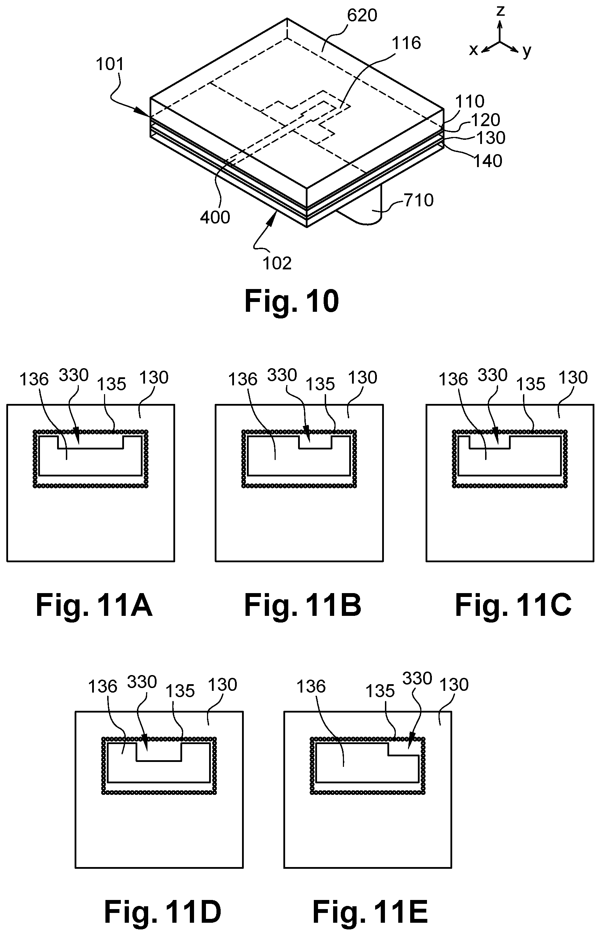

A titre illustratif et non limitatif, les figures 11A à 11Ea représentent plusieurs configurations possibles d'une troisième couche métallique 130 dont une partie 330 fait saillie dans la cavité 136.

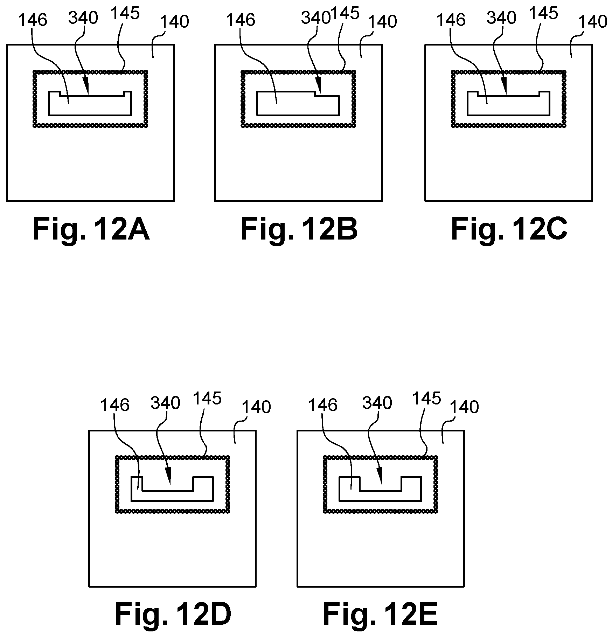

A titre illustratif et non limitatif, les figures 12A à 12E représentent plusieurs configurations possibles d'une quatrième couche métallique 140 dont une partie 340 fait saillie dans la cavité 146.

Ces modes de réalisation peuvent être combinés. Il est possible au sein d'un même dispositif d'utiliser des plaques pour un ou plusieurs niveaux et des parties faisant saillie pour un ou plusieurs niveaux.

L'empilement comprend également des vias métalliques intercouches 250 formés à travers une partie des couches de l'empilement ou à travers toutes les couches de l'empilement de manière à pouvoir connecter différentes couches métalliques 110, 120, 130, 140 les unes avec les autres. Les différentes vias métalliques intercouches permettent de connecter au moins deux couches métalliques entre elles. Elles peuvent connecter plus de deux couches métalliques (par exemple trois couches métalliques ou quatre couches métalliques) entre elles. Les vias métalliques intercouches 250 peuvent être superposés les uns sur les autres ('stacked') ou décalés les uns par rapport aux autres.

Au moins une rangée de vias 115, 125, 135, 145, formée dans chaque couche métallique 110, 120, 130 et 140, entoure, respectivement, les cavités 116, 126, 136, 146. Les rangées de vias 115, 125, 135, 145 aident à confiner les ondes électromagnétiques à l'intérieur de la cavité 116, 126, 136, 146 et/ou empêchent les fuites de signal. Les différentes rangées de vias 115, 125, 135, 145 sont positionnées les unes au-dessus des autres selon l'axe z. Il est possible d'avoir plusieurs rangées de vias 115, 125, 135, 145 par couche métallique 110, 120, 130, 140.

Les couches conductrices 110, 120, 130, 140 et les vias conducteurs 115, 125, 135, 145 forment une structure semblable à un guide d'ondes, par exemple de forme rectangulaire. Le signal RF est confiné et guidé à travers le substrat entre les plaques conductrices, les vias 115, 125, 135, 145 jouant le rôle des parois latérales.

L'utilisation d'un substrat stratifié 100 comprenant des cavités 116, 126, 136, 146 de différentes dimensions et/ou décalées les unes par rapport aux autres et/ou des cavités 116, 126, 136, 146 comprenant des éléments d'adaptation de la fréquence 320, 330, 340 de dimensions différentes et/ou décalés les uns par rapport aux autres conduit à l'obtention d'une traversée RF à large bande et faible perte aux fréquences désirées. Cet empilement permet de s'adapter à toute la bande de radiofréquences recherchées (en particulier 76 GHz - 81 GHz).

De plus, avec un tel substrat 100, il est possible d'obtenir une bande passante un peu plus large que la gamme de fréquence classiquement utilisée dans les radars automobiles (76GHz - 81GHz), ce qui permet d'être moins sensible à la fabrication.

Il est possible de dimensionner les cavités 116, 126, 136, 146 et les éléments d'adaptation 320, 330, 340 en fonction de la fréquence de travail et/ou du substrat.

La taille du dispositif est réduite par rapport aux technologies classiques, notamment celles utilisant des antennes patch. Une intégration complète dans le substrat 100 est obtenue.

L'épaisseur du substrat 100 est, par exemple, comprise entre 100 et 900 µm, par exemple entre 100 et 200 µm, par exemple de l'ordre de 150 µm, ou entre 200 et 300 µm.

Cette traversée compacte et performante peut être réalisée à l'aide d'une technologie de substrat stratifié 100 standard. Les coûts sont ainsi réduits.

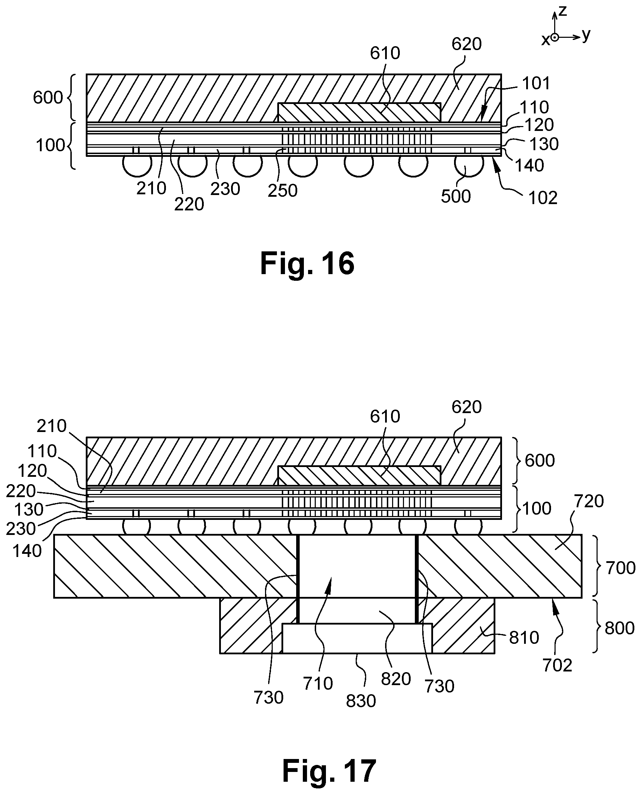

Le substrat 100 décrit précédemment peut être utilisé dans un dispositif radiofréquence (figure 16) ou un système d'émission/réception d'un signal RF (figure 17).

Le dispositif radiofréquence comprend le substrat stratifié 100 et un boitier 600 comprenant au moins un composant électronique et, en particulier, au moins un composant radiofréquence 610 moulé dans un matériau isolant 620, comme un polymère ou une résine.

Le composant radiofréquence 610 est un composant électronique apte à transmettre et recevoir des signaux radiofréquences spécifiques.

En particulier le composant radiofréquence 610 est une puce radiofréquence 610.

La puce 610 présente en face avant des plages de connexion recouverts par des plots métallisés ('bumps' ; non représentés). Les plots métallisés sont par exemple en étain ou en un alliage à base d'étain.

Le composant radiofréquence 610 est assemblé sur le substrat 100.

La puce 610 est montée directement sur le substrat stratifié BGA 100, les plots ('bumps') de la puce 610 sont orientés du côté de la première face 101 du substrat 100 ('flip-chip'). La puce 610 est connectée au substrat BGA par ses plots. Elle pourrait être fixée au substrat par brasage de fil ('wire bonding').

La puce 610 est connectée à la ligne de transmission 400 du substrat 100, par exemple au moyen de microrubans.

Le système d'émission/réception d'un signal RF, comprend le dispositif radiofréquence, positionné sur une première face 701 d'un circuit imprimé 700 (PCB ou 'printed circuit board'), et un module antenne 800 disposé sur une deuxième face 702 du circuit imprimé 700.

Le module antenne 800 comprend un substrat 810 dans lequel est formé un guide d'ondes 820 et des antennes 830.

Le circuit imprimé 700 utilisé est, par exemple fabriqué, en formant des trous 710 traversant dans le substrat 700 et en les métallisant. Les parois latérales 730 des trous traversants 710 confinent les ondes électromagnétiques. Les surfaces supérieure et inférieure du substrat 700 peuvent également être métallisées pour former le guide d'ondes.

Le module antenne 800 est couplé au dispositif radiofréquence grâce aux trous 710 traversant le circuit imprimé 720. Le signal est transmis de manière continue de la puce 610 au PCB 700 puis au guide d'onde 820 et à l'antenne 830 du module antenne 800.

Le substrat BGA 100 est fixé au circuit imprimé 700. En particulier, les billes 500 du BGA sont brasées sur le circuit imprimé 700. Les billes 500 du BGA sont, par exemple, en étain ou en un alliage d'étain, tel que le SAC (alliage d'étain, argent et cuivre).

Une partie des billes 500 du BGA joue le rôle de court guide d'ondes pour transmettre le signal vers le PCB 700.

Le signal est ainsi acheminé à travers le substrat BGA 100, grâce à la traversée RF verticale, jusqu'aux trous 710 formés dans le circuit imprimé 700 puis jusqu'au module antenne 800.

Le substrat 100 peut être fabriqué selon les étapes suivantes :
- déposer la deuxième couche métallique 120 et la troisième couche métallique 130, de part et d'autre de la deuxième couche diélectrique 220,
- former des cavités 126, 136, fermées latéralement dans la deuxième couche métallique 120 et la troisième couche métallique 130,
- déposer la première couche diélectrique 210 et la troisième couche diélectrique 230 de part et d'autre des couches métalliques 120, 130 préalablement déposées,

- former la première couche métallique 110 et la quatrième couche métallique 140 de part et d'autre de la première couche diélectrique 210 et de la troisième couche diélectrique 230,
- former une cavité 116 ouverte sur un de ses côtés dans la première couche métallique 110, et former une cavité 146 fermée latéralement dans la quatrième couche métallique 140,
- former une ligne d'alimentation 400, destinée à être connectée à une puce, la ligne d'alimentation 400 s'étendant dans la cavité 116 ouverte.

Les cavités 116, 126, 136, 146 peuvent être formées, par exemple, par des techniques de microfabrication telles que la lithographie et la gravure.

Les cavités 116, 126, 136, 146 ont des dimensions différentes. La cavité 146 fermée de la quatrième couche métallique 140 a les plus grandes dimensions et la cavité 116 ouverte de la première couche métallique 110 a les plus petites dimensions.

Si le dispositif comprend un ou plusieurs éléments d'adaptation sous forme de plaque métallique, le procédé comprendra également une ou plusieurs étapes au cours de laquelle ou au cours desquelles, on positionne la ou les plaques métalliques dans les cavités correspondantes.

Le procédé peut également comprendre une étape au cours de laquelle on fixe des plots de connexion 500 sur la quatrième couche métallique.

### Exemples illustratifs et non limitatifs

### Exemple 1 et exemple 2 : substrats avec des plaques métalliques ('patch') dans des cavités

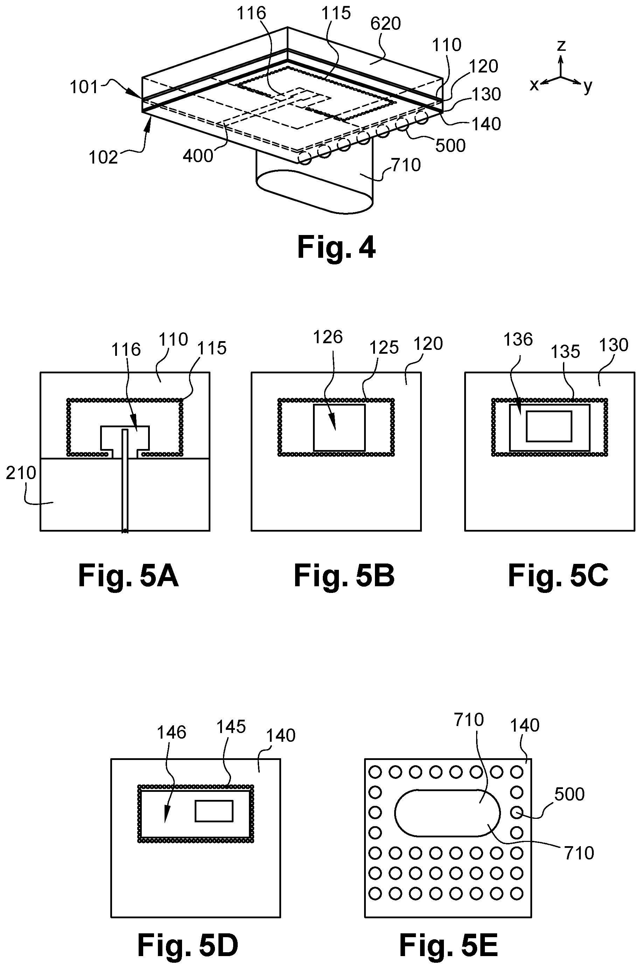

Dans un premier exemple, le substrat BGA 100 est formé des différents éléments représentés sur les figures 3A à 3E et 4. Une plaque métallique est disposée dans la troisième couche métallique 130 et dans la quatrième couche métallique 140.

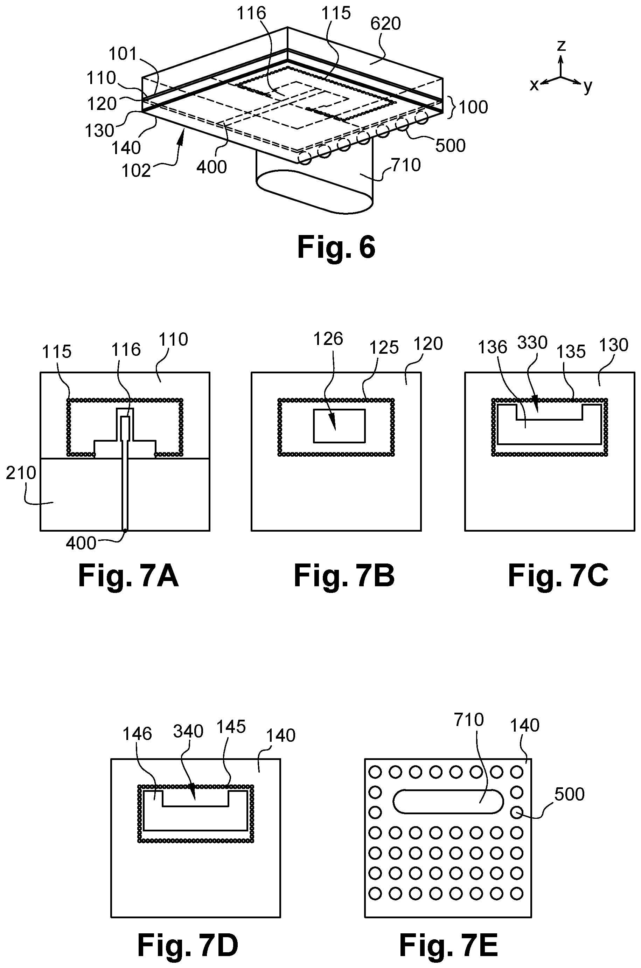

Dans un second exemple, le substrat BGA 100 est formé des différents éléments représentés sur les figures 5A à 5E et 6. Une plaque métallique est disposée dans la troisième couche métallique 130 et dans la quatrième couche métallique 140.

Les principales différences entre les deux exemples sont les suivantes :
- la ligne de connexion 400 du premier niveau est différente et les espaces entre la ligne de transmission 400 et la première cavité 116 sont différents ; ceci permet d'adapter la largeur de bande,
- la deuxième cavité 126 est plus petite dans l'exemple 2 que celle de l'exemple 1 pour obtenir une résonance à plus haute fréquence,
- la quatrième cavité 146 est plus large dans l'exemple 2 que celle de l'exemple 1, et la plaque 340 de la quatrième cavité 146 est décalée dans l'exemple 2 pour obtenir une résonance à plus basse fréquence.

Le troisième niveau de l'exemple 2 est identique à celui de l'exemple 1.

Dans chaque exemple, un PCB 700 est assemblé au substrat BGA 100. Le PCB 700 présente des trous traversants 710 oblongs de 2.54 mm x 1.1 mm jouant le rôle de guide d'onde jusqu'au module antenne.

Une ligne de transmission 400 est reliée à une puce ('bump'), positionnée sur le substrat BGA, et est connectée au guide d'onde SIW ('Substrate integrated waveguide').

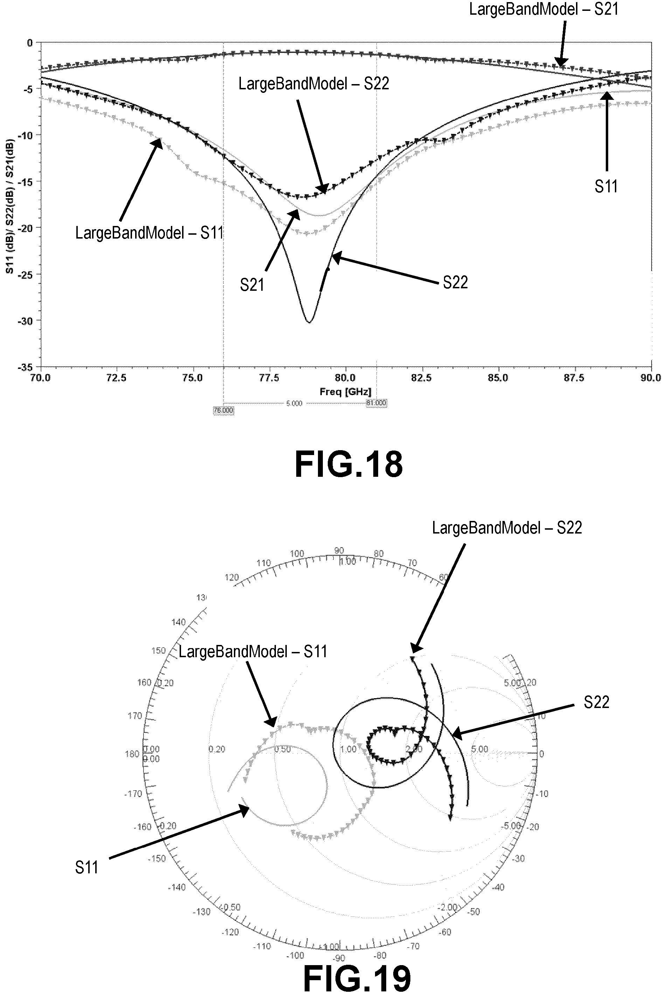

Les performances des deux dispositifs ont été simulées (figures 18 à 20).

Dans le premier exemple, on obtient les performances suivantes : -12 dB / -S11 (76 GHz - 81 GHz).

Dans le deuxième exemple, on obtient les performances suivantes : -15 dB / S11 (76 GHz - 81 GHz), S21 : -1.05 dB plus de flexibilité sur S11/S22 (inférieure à -10 dB) grâce à l'élargissement de bande.

Les deux exemples présentent de bonnes performances.

Le dispositif de l'exemple 1 a une adaptation de largeur de bande étroite à la largeur de bande de fonctionnement par rapport à la version 2.

Le dispositif de l'exemple 2 présente une meilleure adaptation à partir de l'entrée, ce qui améliore légèrement les performances dans les bandes inférieures et supérieures.

Cependant, il est à noter que l'exemple 1 et l'exemple 2 fonctionnent tous les deux aux fréquences recherchées (76 GHz - 81 GHz) et ont les performances attendues.

### Exemple 3 : substrat avec des plaques métalliques dont une partie des plaques font saillie dans des cavités ('slot')

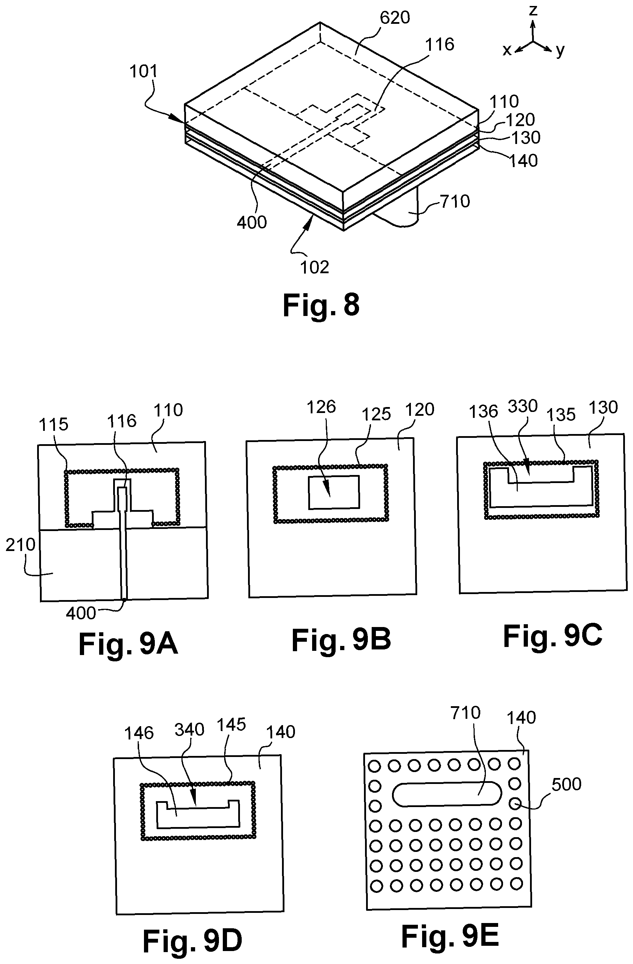

Dans un troisième exemple, le substrat BGA 100 est formé des différents éléments représentés sur les figures 9A à 9E et 10. Une partie 330 de la troisième couche métallique 130 et une partie 340 de la quatrième couche métallique 140 font saillie, respectivement, dans la troisième cavité 136 et dans la quatrième cavité 146.

Par rapport aux exemples 1 et 2, le dispositif de l'exemple 3 présente une réduction de taille d'environ 34%.

Un PCB 700 est assemblé au substrat BGA 100. Le PCB 700 présente des trous traversants 710 oblongs de 2.54 mm x 0.55 mm jouant le rôle de guide d'onde jusqu'au module antenne. La taille du guide d'onde est considérablement réduite (de l'ordre de 50% sur la longueur de la partie oblong).

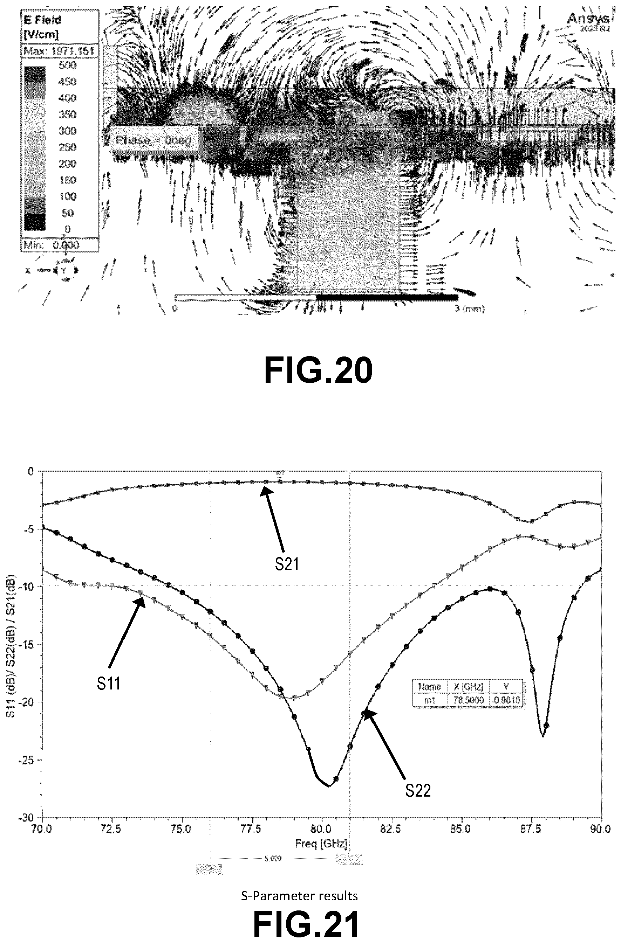

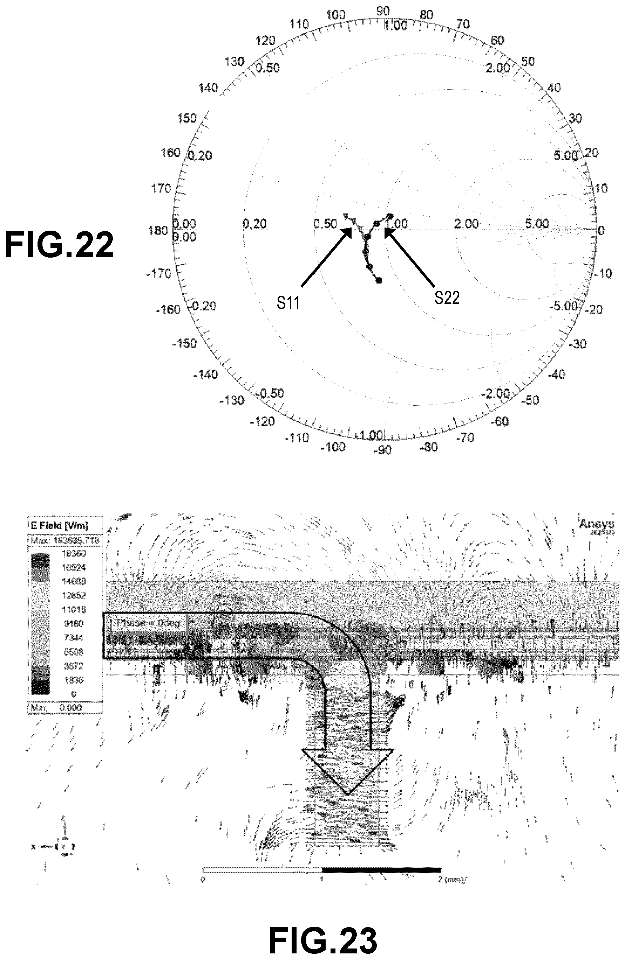

Les performances du dispositif ont été estimées par simulation des paramètres S, ou paramètres de répartition ('Scattering Parameters'). Les paramètres reflètent les propriétés de transmission et de réflexion des réseaux à haute fréquence. Les paramètres S11 et S22 sont inférieurs à -10 dB et S21 est de -0.96 dB : le dispositif obtenu présente de bonnes performances (figures 21 à 23). La propagation des ondes EM montre qu'il n'y a pas de perte d'énergie vers l'extérieur du dispositif.

Avec une extension de signal RF ('RF signal extension') de 400 µm de longueur et une largeur comprise entre 160 et 180 µm et une extension de la connexion de la puce ('die escape extension') ayant une longueur entre 120 et 155 µm et une largeur de 30µm, on obtient les caractéristiques suivantes : S11 : -23 à -20dB à 76GHz -81GHz (Spécification : -20dB min) ; S21: -1.2dB à -1.4dB à 76GHz -81GHz (Spécification : -1.5dB max ).

### Exemple 4 : substrat avec des plaques métalliques dont une partie des plaques font saillie dans des cavités ('slot')

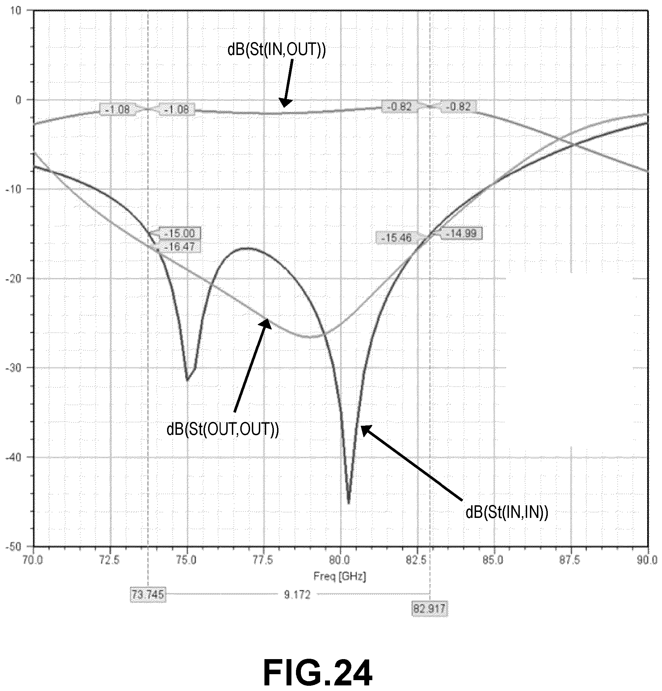

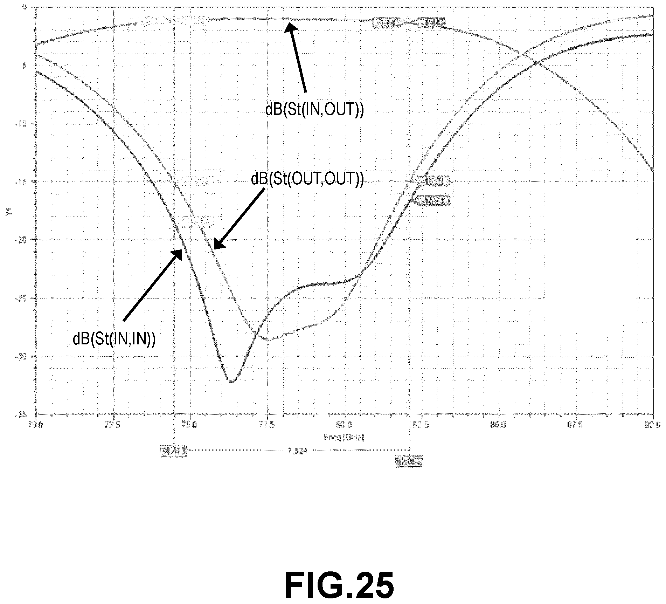

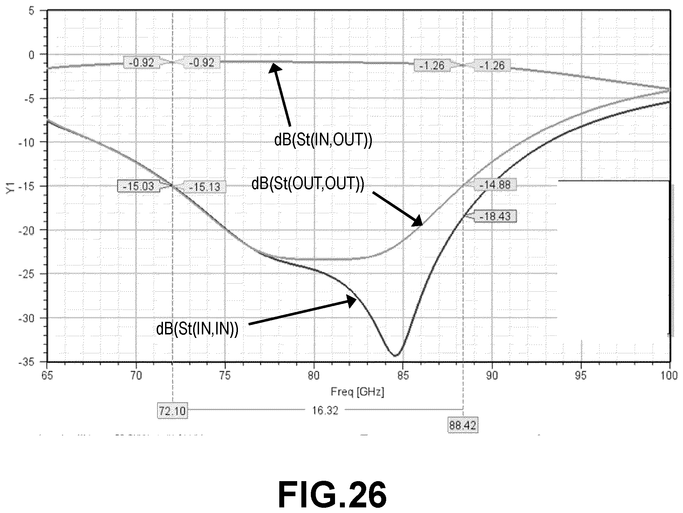

Les performances des dispositifs représentées sur les figures 13A à 13E, 14A à 14F et 15A à 15E ont été simulées. Les résultats obtenus sont représentés, respectivement, sur les figures 24 à 26. Ils montrent qu'une bande très large est obtenue dans la gamme de fréquence recherchée. Ceci permet de réduire la sensibilité due à la tolérance de fabrication.

Des performances de S11 et S22 inférieures à -30 dB et de S12 et S21 supérieures à -0.5 dB peuvent être atteintes.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Substrat stratifié (100) pour dispositif radiofréquence comprenant depuis une première face principale (101) vers une deuxième face principale (102) :
- une première couche métallique (110) dans laquelle est formée une première cavité (116) ouverte au moins partiellement sur un de ses côtés, et une ligne d'alimentation (400), disposée de manière coplanaire à la première couche métallique (110) et s'étendant dans la première cavité (116),
- une première couche diélectrique (210),
- une deuxième couche métallique (120) dans laquelle est formée une deuxième cavité (126) fermée latéralement,
- une deuxième couche diélectrique (220),
- une troisième couche métallique (130) dans laquelle est formée une troisième cavité (136) fermée latéralement,
- une troisième couche diélectrique (230),
- une quatrième couche métallique (140) dans laquelle est formée une quatrième cavité (146) fermée latéralement, la deuxième cavité (126), la troisième cavité (136) et la quatrième cavité (146) formant une traversée radiofréquence verticale dans le substrat (100),
une plaque métallique (340) étant positionnée au moins dans la quatrième cavité (146).

2. Substrat selon la revendication 1, dans lequel une plaque métallique additionnelle (330) est positionnée dans la troisième cavité (136).

3. Substrat selon la revendication précédente, dans lequel la plaque métallique additionnelle (330) positionnée dans la troisième cavité (136) a des dimensions différentes des dimensions de la plaque métallique (340) positionnée dans la quatrième cavité (146).

4. Substrat selon l'une des revendications 2 à 3, dans lequel la plaque métallique (340) et la plaque métallique additionnelle (330) sont décalées l'une par rapport à l'autre.

5. Substrat selon l'une des revendications précédentes, dans lequel une autre plaque métallique (320) est positionnée dans la deuxième cavité (126).

6. Substrat selon l'une des revendications précédentes, dans lequel la première cavité (116), la deuxième cavité (126), la troisième cavité (136) et la quatrième cavité (146) ont des dimensions différentes.

7. Substrat selon l'une des revendications précédentes, dans lequel la troisième cavité (136) a des dimensions inférieures aux dimensions de la quatrième cavité (146) et supérieures aux dimensions de la deuxième cavité (126).

8. Substrat selon l'une des revendications 1 à 6, dans lequel la plaque métallique (340) de la quatrième cavité est positionnée au centre de la quatrième cavité (136).

9. Substrat selon l'une des revendications 1 à 6, dans lequel la plaque métallique (340) positionnée dans la quatrième cavité (146) est décalée par rapport au centre de la quatrième cavité (146).

10. Substrat selon l'une des revendications précédentes, dans lequel des plots de connexion (500) sont fixés à la quatrième couche métallique (140) formant la deuxième face principale (102) du substrat (100).

11. Substrat selon l'une des revendications précédentes, dans lequel une plaque métallique additionnelle (330) est positionnée dans la troisième cavité (136),
la première cavité (116), la deuxième cavité (126), la troisième cavité (136) et la quatrième cavité (146) ayant des dimensions différentes,
des plots de connexion (500) étant fixés à la quatrième couche métallique (140) formant la deuxième face principale (102) du substrat (100).

12. Dispositif radiofréquence comprenant :
- un substrat stratifié (100) tel que défini dans l'une des revendications 1 à 11,
- une puce radiofréquence (610) montée sur la première face (101) du substrat stratifié (100), la puce radiofréquence (610) étant connectée à la ligne d'alimentation (400), moyennant quoi la puce radiofréquence (610) est couplée à la traversée radiofréquence verticale du substrat stratifié (100).

13. Système d'émission/réception d'un signal radiofréquence, comprenant un dispositif radiofréquence tel que défini dans la revendication 12, positionné sur une première face (701) d'un circuit imprimé (700), un module antenne (800) étant disposé sur une deuxième face (702) du circuit imprimé (700), le module antenne (800) comprenant des guides d'ondes (820) et des antennes (830) couplés au dispositif radiofréquence grâce à des trous (710) traversant le substrat (710) du circuit imprimé (700).

14. Procédé de fabrication d'un substrat stratifié (100) tel que défini dans l'une des revendications 1 à 11 comprenant les étapes suivantes :
- déposer la deuxième couche métallique (120) et la troisième couche métallique (130), de part et d'autre de la deuxième couche diélectrique (220),
- former des cavités (126, 136), fermées latéralement, dans la deuxième couche métallique (120) et la troisième couche métallique (130),
- déposer la première couche diélectrique (210) et la troisième couche diélectrique (230) de part et d'autre, respectivement, de la deuxième couche métallique (120) et la troisième couche métallique (130),
- former la première couche métallique (110) et la quatrième couche métallique (140) de part et d'autre, respectivement, de la première couche diélectrique (210) et la troisième couche diélectrique (230),
- former une cavité (116) ouverte sur un de ses côtés dans la première couche métallique (110), et former une cavité (146) fermée latéralement dans la quatrième couche métallique (140),
- positionner une plaque métallique (340) dans la cavité (146) de la quatrième couche métallique (140),
- former une ligne d'alimentation (400), destinée à être connectée à une puce, la ligne d'alimentation (400) étant coplanaire à la première couche métallique (110) et s'étendant dans la première cavité (116) ouverte.
